# EUROPEAN PATENT SPECIFICATION

(11) **EP 0 913 924 B1**
(45) Date of publication and mention of the grant of the patent: **04.06.2003**
(21) Application number: 98308483.1
(22) Date of filing: 16.10.1998
(51) Int. Cl.: H03D 7/16

(54) **Tuner for receiving digital television signals**
Tuner für den Empfang von digitalen Fernsehsignalen
Circuit d' accord pour la réception de signaux de télévision numériques

(30) Priority: 31.10.1997 JP 30045297
(43) Date of publication of application: 06.05.1999
(73) Proprietor: ALPS ELECTRIC CO., LTD., Ota-ku Tokyo 145 (JP)
(72) Inventor: Takayama, Akira, Soma-shi, Fukushima-ken (JP); Tadachi, Akio, Soma-shi, Fukushima-ken (JP); Tanaka, Ryoichi, Soma-shi, Fukushima-ken (JP)
(74) Representative: Kensett, John Hinton

(56) References cited:
- EP-A- 0 186 593
- US-A- 4 686 570
- US-A- 4 717 990

## Description

The present invention relates to a digital television signal receiving tuner, and particularly to a digital television signal receiving tuner wherein a clock circuit is provided integrally therewith.

Digital TV (television) broadcasts have already been put to practice use in satellite broadcasting and CATV (Cable Television). However, a so-called digital TV broadcast using a ground wave is recently on its way to becoming planned.

A digital TV receiver for receiving this digital TV broadcast therein comprises an A/D (analog/digital) converter for sampling an intermediate frequency signal sent from a tuner, a clock oscillator for inputting a sampling clock signal to the A/D converter, a baseband processing circuit for processing a parallel 8-bit digital signal outputted from the A/D converter, etc.

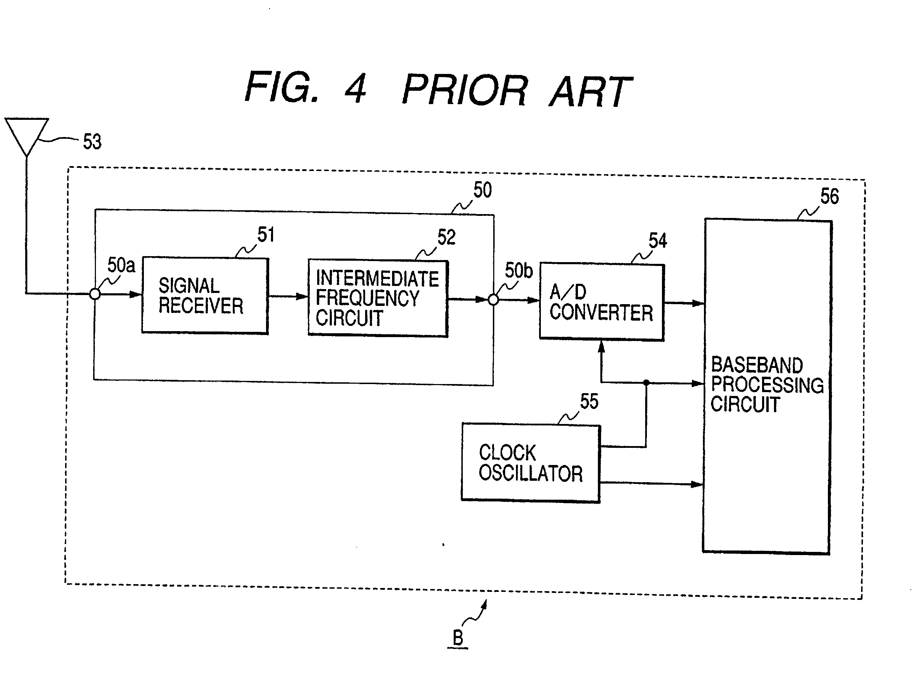

Fig. 4 is a block configurational diagram showing a tuner, an A/D (analog/digital) converter, a clock oscillator and a baseband processing circuit all placed on a conventional motherboard.

As shown in Fig. 4, a tuner 50, an A/D converter 54 different in configuration from the tuner 50, a clock oscillator 55 different in configuration from the tuner 50, and a baseband processing circuit 56 are provided on a motherboard B of a digital TV receiver. Further, the tuner 50 includes a signal receiver 51 and an intermediate frequency circuit 52.

Moreover, the tuner 50 has a tuner input terminal 50a for receiving a television signal received by an antenna 53, and a tuner output terminal 50b for sending an intermediate frequency signal. The signal receiver 51 for frequency-converting the television signal to a first intermediate frequency signal and outputting the first intermediate frequency signal, and the intermediate frequency circuit 52 for performing signal processes such as the amplification of the first intermediate frequency signal sent from the signal receiver 51, the frequency conversion thereof into another, etc., frequency-converting the first intermediate frequency signal to a second intermediate frequency signal, and outputting the converted signal therefrom are constructed within one casing.

The A/D converter 54 for converting a second intermediate frequency signal sent from a tuner output terminal 50b of the tuner 50 to a parallel 8-bit baseband signal and the clock oscillator 55 for sending a clock signal of about 18MHz for sampling the second intermediate frequency signal are respectively accommodated within a shield case, for example. The respective circuits (units) are individually configured on the motherboard. The clock oscillator 55 transmits a clock signal of about 36MHz as well as a clock signal of about 18MHz therefrom.

The parallel 8-bit baseband signal sent from the A/D converter 54 is inputted to the baseband processing circuit 56 individually held in a shield case, for example, where a signal process such as demodulation or the like is effected on the signal, so that a video signal and a sound or audio signal are taken out. The clock signals of about 18MHz and 36MHz produced from the clock oscillator 55 are inputted to the baseband processing circuit 56. From this construction, the A/D converter 54 and the baseband processing circuit 56 are in synchronization with each other.

However, the conventional digital TV receiver has a problem in that since the tuner 50, the A/D converter 54, the clock oscillator 55 and the baseband processing circuit 56 are respectively individually placed on the motherboard B, they must be completed as individual units in advance and hence the number of manhours necessary for assembly increases, the placement of the respective units becomes complex and the number of manhours necessary for design of the motherboard B increases, whereby the cost of the TV receiver will be high.

Further, the clock oscillator 55 externally placed aside from the tuner 50 on the motherboard B transmits the clock signals of about 18MHz and 36MHz as described above. However, the signal level of the clock signals is about 5V, which is high in signal level, and many harmonic signals such as a received frequency of the tuner 50, a frequency signal coincident with a first intermediate frequency, etc. are included in the neighborhood of rise and fall waveforms of each clock signal referred to above. A problem arises in that since these harmonic signals are high in signal level as is like 5V, they leap out from a signal line for sending, e.g. a clock signal from the clock oscillator 55 placed on the motherboard B so as to go round to the tuner input terminal 50a of the tuner 50, thereby interfering with the tuner 50.

With the foregoing problems in view, it is therefore an object of the present invention to provide a digital television signal receiving tuner wherein the assembly of a digital TV receiver is simple, the placement of respective circuit units on a motherboard B is simplified, the number of manhours necessary for design of the motherboard B may be less, and interference caused by harmonic signals which are included in a clock signal produced from a clock oscillator, for sampling a second intermediate frequency signal by an A/D converter can be avoided.

According to one aspect of this invention, there is provided a digital television signal receiving tuner, comprising: an input terminal to which a television signal is inputted; a signal receiver for frequency-converting the television signal to a first intermediate frequency signal corresponding to a television intermediate frequency signal; an intermediate frequency circuit for frequency-converting the first intermediate frequency signal outputted from the signal receiver to a second intermediate frequency signal lower than the first intermediate frequency signal in frequency; an analog/digital converter circuit for converting the second intermediate frequency signal outputted from the intermediate frequency circuit to a digital signal; and a clock circuit for generating a clock signal for sampling the second intermediate frequency signal by the analog/digital converter circuit, and wherein the tuner is placed within a casing composed of a metal plate and provided with a plurality of compartments and the clock circuit is placed within a compartment provided at a position farthest from the input terminal.

The digital television signal receiving tuner may be constructed such that filters for causing the clock signals sent from the clock circuit to pass therethrough are interposed in lines for sending the clock signals.

Preferably, the digital television signal receiving tuner is constructed such that a double shield is formed in the clock circuit.

Preferably, the digital television signal receiving tuner is provided with clock signal output terminals for sending the clock signals delivered from the clock circuit placed within the casing from the casing.

### BRIEF DESCRIPTION OF THE DRAWINGS

While the specification concludes with claims particularly pointing out and distinctly claiming the subject matter which is regarded as the invention, it is believed that the invention, the objects and features of the invention and further objects, features and advantages thereof will be better understood from the following description taken in connection with the accompanying drawings in which:
Fig. 1 is a block diagram for describing a state in which a digital television signal receiving tuner according to an embodiment of the present invention and a baseband processing circuit are incorporated into a motherboard of a TV receiver, using the digital television signal receiving tuner according to the embodiment of the present invention;
Fig. 2 is a plan view showing a casing with the digital television signal receiving tuner shown in Fig. 1 disposed therein, the casing is held in a state in which upper and lower covers have been removed from the casing;
Fig. 3 is an explanatory view for describing a low-pass filter placed in the digital television signal receiving tuner shown in Fig. 1; and
Fig. 4 is a block diagram showing a state in which a tuner, an A/D converter, a clock oscillator and a baseband processing circuit are incorporated into a conventional motherboard.

Preferred embodiments of the present invention will hereinafter be described in detail with reference to the accompanying drawings, by way of example only,

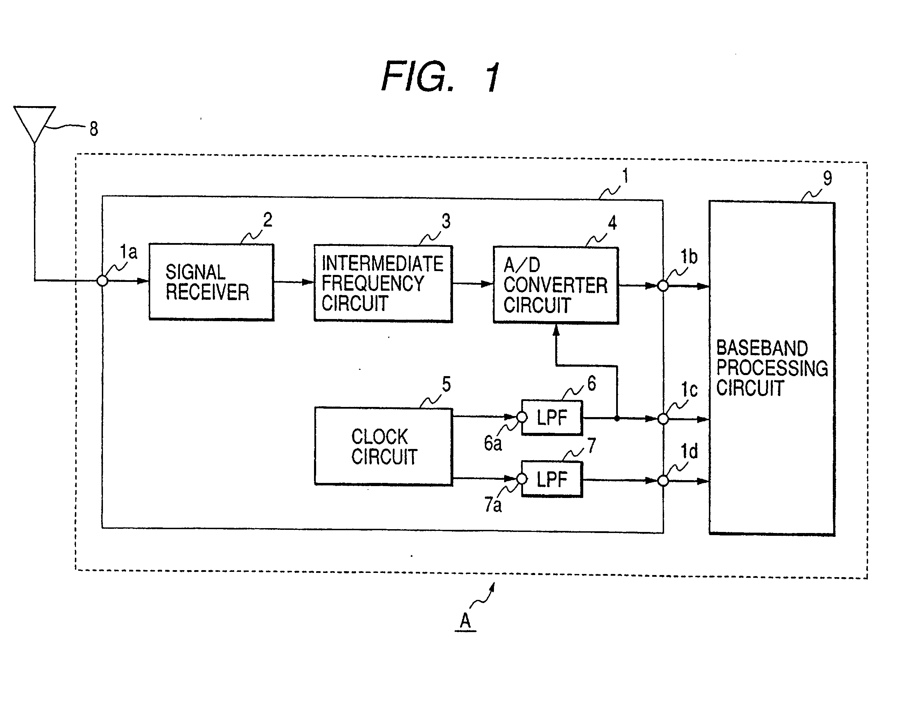

Fig. 1 is a block diagram for describing a state in which a digital television signal receiving tuner (hereinafter called "tuner") according to the present invention and a baseband processing circuit are incorporated into a motherboard of a TV receiver, using the digital television signal receiving tuner.

As shown in Fig. 1, a motherboard A has a tuner 1 and a baseband processing circuit 9. The tuner 1 and the baseband processing circuit 9 are held or accommodated within their corresponding individual casings.

Further, the tuner 1 includes respective circuit units to be described later, which are respectively held and configured on a single printed wiring board placed within one casing so that they are shielded. Thus, the respective circuit units, which constitute the tuner 1, can be completed in one assembly work.

Moreover, the tuner 1 has a signal receiver 2 for selecting a TV (television) signal inputted to a tuner input terminal 1a and frequency-converting it to a first intermediate frequency signal corresponding to a TV intermediate frequency signal, an intermediate frequency circuit 3 for performing signal processes such as the amplification of the first intermediate frequency signal sent from the signal receiver 2, the frequency conversion thereof into another, etc., converting the first intermediate frequency signal to a second intermediate frequency signal lower than the first intermediate frequency signal in frequency and outputting the converted signal therefrom, an A/D (Analog/Digital) converter circuit 4 for converting the second intermediate frequency signal whose center frequency is about 4MHz, which is sent from the intermediate frequency circuit 3, to a baseband signal represented in the form of parallel 8 bits, a clock circuit 5 for sending a first clock signal of about 18MHz used for sampling the second intermediate frequency signal by the A/D converter circuit 4, and a tuner output terminal 1b for outputting the baseband signal sent from the A/D converter circuit 4 to the outside of the tuner 1. As described above, the A/D converter circuit 4 and the clock circuit 5 are integrated into one and incorporated into the tuner 1.

The clock circuit 5 transmits a second clock signal of about 36MHz as well as the first clock signal of about 18MHz therefrom. A first LPF (Low-Pass Filter) 6 provided with an input terminal 6a, which allows, e.g., only a frequency signal of 18MHz or less to pass therethrough, is placed in a transmission line for sending the first clock signal. The first clock signal is inputted to the A/D converter circuit 4 through the first LPF 6 to sample the second intermediate frequency signal by the A/D converter circuit 4 and is outputted to the outside of the tuner 1 through a clock signal output terminal 1c. Similarly, the second clock signal is outputted from a clock signal output terminal 1d to the outside of the tuner 1 through a second LPF (Low-Pass Filter) 7 provided with an input terminal 7a, which allows, e.g., only a frequency signal of less than or equal to 36 MHz to pass therethrough. Harmonic signals contained in the first and second clock signals can be cut by the first and second LPFs 6 and 7 respectively.

The first clock signal may be directly inputted from the clock circuit 5 to the A/D converter circuit 4 without being sent through the first LPF 6. At this time, the first LPF 6 is electrically connected directly to the clock signal output terminal 1c without being via a connecting point to the A/D converter circuit 4.

Incidentally, the filter is not necessarily limited to the LPF and may be a bandpass filter which allows only the clock signals to pass therethrough.

The parallel 8-bit baseband signal sent from the A/D converter circuit 4 is inputted via the tuner output terminal 1b to the baseband processing circuit 9 held in one casing (shielding case) attached to the outside of the tuner 1, where a signal process such as QPSK demodulation or the like is effected on the signal, so that a video signal and a sound or audio signal are taken out.

As described above, the first clock signal of about 18 MHz and the second clock signal of about 36MHz are transmitted from the clock circuit 5 to perform the QPSK demodulation or the like by the baseband processing circuit 9. The first and second clock signals are sent to the outside of the tuner 1 through the clock signal output terminals 1c and 1d, followed by input to the baseband processing circuit 9. Further, since the first clock signal is inputted to each of the A/D converter circuit 4 and the baseband processing circuit 9 as described above and are used for both circuits, the A/D converter circuit 4 and the baseband processing circuit 9 are in synchronism with each other.

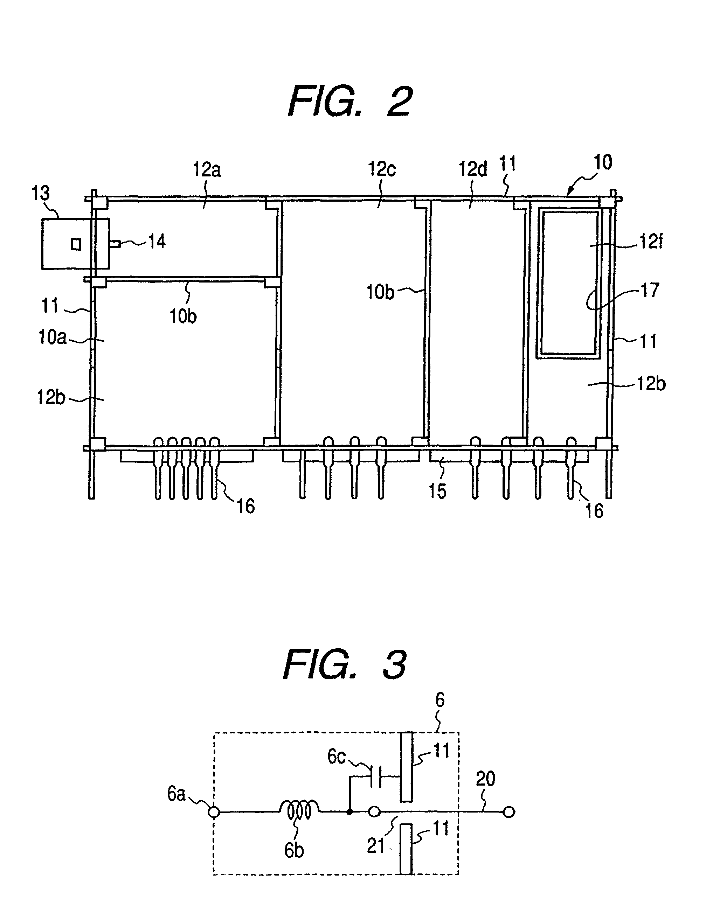

The casing in which the digital television signal receiving tuner according to the embodiment of the present invention is placed therein, will now be explained with reference to Fig. 2.

Fig. 2 is a plan view showing a casing with the digital television signal receiving tuner according to the embodiment of the present invention disposed therein, the casing is held in a state in which upper and lower covers have been removed from the casing.

As shown in Fig. 2, a frame body 10 composed of a flat metal material and folded-shaped in case form comprises side walls 11 which surround at least the four sides, an upper opening 10a and a lower opening (not shown) defined by the side walls 11, and partition walls 10b, 10b, ... made up of a plurality of pieces (e.g., four) of metal plates for dividing a space portion defined by the side walls 11 into plural pieces such as five first to fifth compartments 12a, 12b, 12c, 12d and 12e. The first to fifth compartments 12a, 12b, 12c, 12d and 12e are respectively shielded (screened) by the side walls 11 and the partition walls 10b.

Although the number of the compartments is formed as five in the embodiment of the present invention, it is not limited to this. A desired number of compartments, even seven or ten may be formed.

An input terminal 13 has a central conductor 14 and is provided so as to input a TV signal received from an antenna (not shown) to the tuner 1 (see Fig. 1). Further, the input terminal 13 is placed above the side wall 11 extending in the transverse direction of the frame body 10. An end of the central conductor 14 is disposed within the first compartment 12a which constitutes a first stage. This input terminal 13 corresponds to the tuner input terminal 1a (see Fig. 1).

Flat printed wiring boards 15 each composed of a sheet of insulating material are rectangular in shape. Although not shown in the drawing, electrical components such as coils, integrated circuits, etc. are mounted on one surface of each printed wiring board 15, whereas predetermined circuit patterns are formed on the other surface thereof. Further, each printed wiring board 15 is inserted and placed from the opening (not shown) below the frame body 10 to the upper part lying within the frame body 10.

A plurality of flat terminals 16, 16, ... each composed of a metal material are attached and connected to one end of the printed wiring boards 15. The plurality of terminals 16 constitute a power supply terminal for supplying power from a power circuit (not shown), clock signal output terminals 1c and 1d for transferring clock signals outputted from the clock circuit 5 (see Fig. 1), a tuner output terminal 1b for transmitting a baseband signal outputted from the A/D converter circuit 4, etc. These terminals 16 are respectively electrically connected to the circuit patterns of the printed wiring boards 15.

Although not shown in the drawing, there are provided flat upper and lower covers each comprised of a metal material, which cover the upper opening 10a and lower opening (not shown) of the frame body 10. The casing is shielded over its entirety by the upper and lower covers and the frame body 10. The first to fifth compartments 12a, 12b, 12c, 12d and 12e formed by the partition walls 10b for dividing the space defined by the side walls 11 into them are respectively individually shielded.

A side wall 17 formed by bending and processing a metal plate, which surrounds the four sides, and an upper cover (not shown) for covering an upper opening defined by the side wall 17 are placed on the printed wiring board 15 placed within the fifth compartment 12e. A sixth compartment 12f is defined by the side wall 17. Thus, the sixth compartment 12f has a double-shielded structure in which a first shield is performed by the side wall 17 and the upper cover and a second shield is done by the side walls 11 and the partition walls 10b both placed on the outer side of the side wall 17, and the upper and lower covers (not shown).

The respective circuit parts (units) of the tuner 1 shown in Fig. 1 are placed within their corresponding first to fifth compartments 12a, 12b, 12c, 12d and 12e of the casing constructed as described above.

The relationship between the first to fifth compartments 12a, 12b, 12c, 12d and 12e and the respective block configurational diagrams of the tuner 1 (see Fig. 1), which are respectively placed therewithin, will now be explained.

First of all, unillustrated electrical components and circuit patterns, which constitute the signal receiver 2, are placed on the printed wiring board 15 so as to fall within the first compartment 12a corresponding to a first stage and the second compartment 12b corresponding to the next stage as viewed from the input terminal 13 side of the casing. Similarly, the intermediate frequency circuit 3 is placed on the printed wiring board 15 so as to fall within the third compartment 12c corresponding to the following stage. Likewise, the A/D converter circuit 4 is placed on the printed wiring board 15 so as to be held within the fourth compartment 12d corresponding to the next stage. Further, similarly, unillustrated electrical components and circuit patterns, which constitute the clock circuit 5 and the respective LPFs (Low-Pass Filters) 6 and 7, are placed on the printed wiring board 15 so as to fall within the fifth compartment 12e corresponding to the final stage as viewed from the input terminal 13 side.

The clock circuit 5 is placed within the sixth compartment 12f defined by the side wall 17 and provided in double-shielded form. The sixth compartment 12f is disposed at a position farthest from the input terminal 13.

Further, the respective circuit portions shown in the respective block configurational diagrams described above are respectively placed within the shielded compartments to prevent mutual effect of signals which pass through the respective circuit portions.

One embodiment of a specific configuration at the time that the low-pass filter 6 is directly connected to the output terminal 1c (even the LPF 7 is similarly connected thereto), will next be described here in detail.

As shown in Fig. 3, the low-pass filter 6 comprises an input terminal 6a, a coil 6b electrically connected to the input terminal 6a, a capacitor 6c electrically connected to one end of the coil 6b, and an output terminal 20 made up of a metal bar, which is electrically connected directly to the coil 6b. The output terminal 20 is placed so as to extend from the inner side of a side wall 11 of a casing, which is composed of a metal plate, to the outer side thereof as viewed from a hole 21 defined in the side wall 11. The capacitor 6c is placed so that one end thereof is electrically connected to the coil 6b and the other end thereof is electrically connected to the side wall 11. The capacitor 6c and the coil 6b constitute the low-pass filter 6.

As described above, the clock circuit 5 for transmitting the clock signal for sampling the second intermediate frequency signal by the A/D converter circuit 4 is formed integrally with the tuner 1 (incorporated into the tuner 1) and the whole is configured within one casing. Thus, since only-the two circuits (casings) of the tuner 1 and the baseband processing circuit 9 are mounted and placed on the motherboard A, the placement of the respective circuits on the motherboard A becomes simple.

Further, since the clock circuit 5 is placed within the final compartment located at the position farthest as viewed from the input terminal 13 side, the harmonic signals contained in the clock signals are not inputted to the input terminal 1a through the respective circuits placed within the tuner 1. Therefore, there is no interference with the tuner 1 by the harmonic signals included in the clock signals.

As has been described above, a clock circuit for generating clock signals for sampling a second intermediate frequency signal by an analog/digital converter circuit is incorporated into a digital television signal receiving tuner of the present invention comprising a signal receiver for frequency-converting a television signal to a first intermediate frequency signal corresponding to a television intermediate frequency signal, an intermediate frequency circuit for frequency-converting the first intermediate frequency signal outputted from the signal receiver to the second intermediate frequency signal lower than the first intermediate frequency signal in frequency, and the analog/digital converter circuit for converting the second intermediate frequency signal outputted from the intermediate frequency circuit to a digital signal. Thus, the clock circuit is formed integrally with the tuner into one circuit configuration. Owing to this construction, an advantageous effect is brought about in that the tuner with the clock circuit formed integrally therewith is completed by one assembly and the number of manhours necessary for assembly can be reduced. Further, an advantageous effect is brought about in that the simple placement of the two circuit configurations of digital television signal receiving tuner and baseband processing circuit alone on a motherboard of a TV receiver allows the assembly of the motherboard and permits simplification of their placement because only the two circuit configurations are placed on the motherboard, whereby the design and assembly costs of the motherboard become cheaper.

Further, a digital television signal receiving tuner of the present invention, which has an input terminal to which a television signal is inputted, and comprises a signal receiver for frequency-converting the television signal to a first intermediate frequency signal corresponding to a television intermediate frequency signal, an intermediate frequency circuit for frequency-converting the first intermediate frequency signal outputted from the signal receiver to a second intermediate frequency signal lower than the first intermediate frequency signal in frequency, an analog/digital converter circuit for converting the second intermediate frequency signal outputted from the intermediate frequency circuit to a digital signal, and a clock circuit for generating clock signals for sampling the second intermediate frequency signal by the analog/digital converter circuit, is placed within a casing composed of a metal plate and provided with a plurality of compartments. Further, the clock circuit is placed within a compartment provided at a position farthest from the input terminal. Therefore, harmonic signals included in the clock signals generated from the clock circuit are less input from the input terminal and the occurrence of interference with the tuner by the harmonic signals in the clock signals is reduced.

Moreover, since the digital television signal receiving tuner of the present invention is provided with filters for causing clock signals sent from a clock circuit to pass through transmission lines used for the clock signals, the filters attenuate harmonic signals contained in the clock signals so as to allow only desired clock signals to pass therethrough. Therefore, the occurrence of interference with the tuner by the harmonic signals included in the clock signals is reduced.

Still further, the digital television signal receiving tuner of the present invention is constructed such that since a double shield is formed in the clock circuit, the harmonic signals included in the clock signals outputted from the clock circuit are not outputted to the outside of the clock circuit by the double shield, whereby the occurrence of interference with the tuner by the harmonic signals included in the clock signals is reduced.

Still further, the digital television signal receiving tuner of the present invention is constructed such that clock signal output terminals for transferring the clock signals sent from the clock circuit placed within the casing from the casing are attached to the casing so as to input the clock signals transferred from the clock signal output terminals to a baseband processing circuit electrically connected to a subsequent stage of the tuner, whereby the baseband processing circuit can utilize each clock signal synchronized with that from the analog/digital converter circuit.

While the present invention has been described with reference to the illustrative embodiments, this description is not intended to be construed in a limiting sense. Various modifications of the illustrative embodiments will be apparent to those skilled in the art on reference to this description.

## Claims

1. A digital television signal receiving tuner (1) comprising:
an input terminal to (1a) which a television signal is inputted;
a signal receiver (2) or frequency-converting the television signal to a first intermediate frequency signal corresponding to a television intermediate frequency signal;
an intermediate frequency circuit (3) for frequency-converting the first intermediate frequency signal outputted from said signal receiver to a second intermediate frequency signal which is lower than the first intermediate frequency signal in frequency;
an analog/digital converter circuit (4) for converting the second intermediate frequency signal outputted from the intermediate frequency circuit to a digital signal; and
a clock circuit (5) for generating a clock signal for sampling the second intermediate frequency signal by said analog/digital converter circuit,
wherein said tuner is placed within a casing (10) composed of a metal plate and provided with a plurality of compartments (12a - 12f) and said clock circuit is placed within a compartment (12f) provided at a position farthest from the input terminal.

2. The digital television signal receiving tuner according to Claim 1, wherein filters for attenuating harmonic signals contained in the clock signals are interposed in lines for transmitting the clock signals delivered from said clock circuit.

3. The digital television signal receiving tuner according to Claim 1 or 2, wherein the compartment in which said clock circuit is placed has a double-shielded structure.

4. The digital television signal receiving tuner according to Claims 1, 2 or 3, further comprising clock signal output terminals for transferring the clock signals sent from said clock circuit placed within the casing from the casing.

## Patentansprüche

1. Digitaler Fernsehsignal-Empfangstuner (1) mit:
einem Eingangsanschluss (1a), in den ein Fernsehsignal eingegeben wird;
einem Signalempfänger (2) für die Frequenzkonvertierung des Fernsehsignals in ein erstes Zwischenfrequenzsignal, welches einem Fernseh-Zwischenfrequenzsignal entspricht;
einer Zwischenfrequenzschaltung (3) für die Frequenzkonvertierung des ersten Zwischenfrequenzsignals, das vom Signalempfänger ausgegeben worden ist, in ein zweites Zwischenfrequenzsignal, welches in der Frequenz niedriger als das erste Zwischenfrequenzsignal ist;
einer Analog-/Digital-Konverterschaltung (4) für die Konvertierung des zweiten Zwischenfrequenzsignals, das von der Zwischenfrequenzschaltung in ein digitales Signal ausgegeben worden ist; und
einem Taktgebergenerator (5) zur Erzeugung eines Taktsignals für das Abtasten des zweiten Zwischenfrequenzsignals durch die Analog-/Digital-Konverterschaltung,
wobei der Tuner in einem Gehäuse (10) untergebracht ist, das sich aus einer Metallplatte zusammensetzt und mit einer Vielzahl von Zellen (12a - 12f) ausgestattet ist, und wobei der Taktgebergenerator innerhalb einer Zelle (12f) an einer Position untergebracht ist, die zum Eingangsanschluss am weitesten entfernt gelegen

2. Digitaler Fernsehsignal-Empfangstuner nach Anspruch 1, wobei Filter zur Dämpfung von Oberwellensignalen, die in den Taktsignalen vorhanden sind, in den Leitungen für die Übertragung der vom Taktgebergenerator erhaltenen Taktsignale dazwischen geschaltet werden.

3. Digitaler Fernsehsignal-Empfangstuner nach Anspruch 1 oder 2, wobei die Zelle, in welcher der Taktgebergenerator 5 untergebracht ist, eine doppelte Abschirmkonstruktion aufweist.

4. Digitaler Fernsehsignal-Empfangstuner nach . den Ansprüchen 1, 2 oder 3, welcher ferner Taktsignal-Ausgangsanschiüsse zum Weiterleiten der vom Taktgebergenerator gesendeten Taktsignale aufweist, die in einem Gehäuseteil des Tunergehäuses nach außen führend angeordnet sind.

## Revendications

1. Un circuit d'accord (1) pour la réception de signaux de télévision numériques, comprenant:
une borne d'entrée (10) dans laquelle est introduit un signal de télévision; un receveur de signaux (12) pour la conversion du signal de télévision à une première fréquence intermédiaire correspondant à un signal de fréquence intermédiaire de télévision;
un circuit de fréquence intermédiaire (3) pour convertir le premier signal de fréquence intermédiaire émis du receveur de signaux en un deuxième signal de fréquence intermédiaire qui est de fréquence plus basse que le premier signal de fréquence intermédiaire;
un circuit (4) de conversion analogique/numérique pour convertir le deuxième signal intermédiaire de fréquence émis du circuit de fréquence intermédiaire à un signal numérique; et
un circuit d'horloge (5) pour générer un signal d'horloge pour échantillonner le deuxième signal intermédiaire de fréquence par ledit circuit de conversion analogique/numérique,
dans lequel le circuit d'accord est placé à l'intérieur d'un boîtier (10) composé d'une plaque de métal et pourvu d'un nombre de compartiments (12, 12f) et le circuit d'horloge est placé à l'intérieur d'un compartiment (12f) prévu à une position la plus éloignée de la borne d'entrée.

2. Le circuit d'accord pour la réception de signaux de télévision numériques selon la revendication 1, dans lequel des filtres pour atténuer les signaux harmoniques contenus dans les signaux d'horloge sont interposés en lignes pour transmettre les signaux d'horloge provenant du circuit d'horloge.

3. Le circuit d'accord pour la réception de signaux de télévision numériques selon la revendication 1 ou 2, dans lequel le compartiment dans lequel est placé le circuit d'horloge a une structure doublement blindée.

4. Le circuit d'accord pour la réception de signaux de télévision numérique selon les revendications 1, 2 ou 3, comprenant de surcroît des bornes de sortie de signaux d'horloge pour transférer les signaux d'horloge envoyés par le circuit d'horloge placé à l'intérieur du boîtier.
